(19) Europäisches Patentamt

European Patent Office

Office européen des brevets

(11) **EP 1 166 442 B1**

(12) **EUROPEAN PATENT SPECIFICATION**

(45) Date of publication and mention
of the grant of the patent:
**22.10.2003 Bulletin 2003/43**

(51) Int Cl.$^7$: **H03H 17/02**

(86) International application number:
**PCT/US00/08985**

(21) Application number: **00921691.2**

(22) Date of filing: **03.04.2000**

(87) International publication number:
**WO 00/060738 (12.10.2000 Gazette 2000/41)**

(54) **COMPLEX MATCHED FILTER WITH REDUCED POWER CONSUMPTION**

KOMPLEXES SIGNALANGEPASSTES FILTER MIT REDUZIERTEM ENERGIEVERBRAUCH

FILTRE ADAPTE COMPLEXE A CONSOMMATION D'ENERGIE REDUITE

(84) Designated Contracting States:
**AT BE CH CY DE DK ES FI FR GB GR IE IT LI LU MC NL PT SE**

(30) Priority: **06.04.1999 US 286503**

(43) Date of publication of application:
**02.01.2002 Bulletin 2002/01**

(73) Proprietor: **ERICSSON INC.**
**Research Triangle Park, NC 27709 (US)**

(72) Inventor: **DENT, Paul, W.**
**Pittsboro, NC 27312 (US)**

(74) Representative: **Stenborg, Anders Vilhelm**
**Aros Patent AB,**
**P.O. Box 1544**
**751 45 Uppsala (SE)**

(56) References cited:
- **NORM COUTURIER ET AL: "Experimental Results for Four Phase Digital Matched Filtering of Spread Spectrum Waveforms" IEEE TRANSACTIONS ON COMMUNICATIONS,US,IEEE INC. NEW YORK, vol. COM-34, no. 8, August 1986 (1986-08), pages 836-840-840, XP002108864 ISSN: 0090-6778**
- **NAUERZ R ET AL: "THE SUITABILITY OF MODERN CMOS GATE ARRAY CIRCUITS AS CORRELATORS AND MATCHED FILTERS FOR SPREAD-SPECTRUM SIGNALS" PROCEEDINGS OF THE MILITARY COMMUNICATIONS CONFERENCE. (MILCOM),US,NEW YORK, IEEE, vol. CONF. 6, 1987, pages 473-478, XP000124771**

**Description**

Related Application

This Application is a Continuation-in-Part of U.S. Application Serial No. 08/748,755 filed on November 14, 1996.

BACKGROUND OF THE INVENTION

Technical Field of the Invention

The present invention relates generally to radio receivers for receiving and despreading direct sequence spread spectrum signals, also known as Code Division Multiple Access (CDMA) signals, and more particularly, to a complex matched filter for use in a receiver which reduces power consumption by using CDMA waveforms using complex despreading codes.

Description of Related Art

General background information related to the present invention may be provided e.g. from Nauerz, R., et al: "The suitability of modern CMOS gate array circuits as correlators and matched filters for spread-spectrum signals" *Proceedings of the Military Communications Conference*, (Milcom), US, New York, IEEE vol. Conf. 6, 1987, pp. 473-478, XP000124771. This article discloses a digital correlation processing unit for a complex correlation of spread spectrum signals.

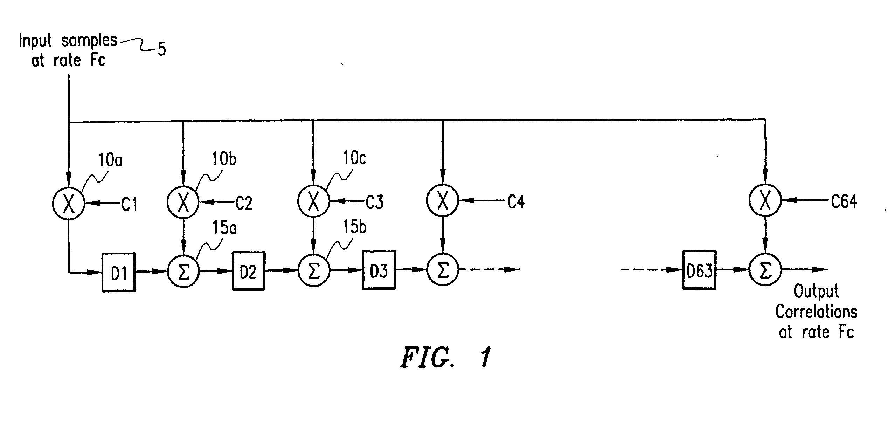

FIGURE 1 illustrates a prior art matched filter type of correlator for correlating real values. A received signal is sampled at a rate Fc samples per second and the samples 5 are entered sequentially to the input of a number of multipliers 10. Each multiplier 10 includes a second input for receiving a code value C1. The present example illustrates a matched filter having a length of 64. A current input sample $S_i$ is multiplied by the code value C1 in the left most multiplier 10a, and the output $C1.S_i$ is input to a one sample delay element D1. The value $C1.S_i$ emerges from the delay element D1 during the next sample period when the input sample value S(i+1) is input to the inputs of each of the multipliers 10. As the value $C1.S_i$ emerges from the delay element 01 and is applied to the input of a first summer 15a, the multiplier 10b multiplies input sample S(i+1) by the input code C2 to obtain a value C2.S(i+1). This is applied to the second input of the first summer 15a.

The output from the summer 15a of (Cl.$S_i$ + C2.S(i+1)) is input into a second delay element D2. This value emerges from the delay element D2 during the next sample period when S(i+2) is input to the multipliers 10. The output from D2 is added to the value C3.S(i+2) at summer 15b, and the output of summer 15b is applied to a first input of delay element D4. This process continues in a similar manner until 64 samples have been input to the filter, a value emerges from the rightmost summer 15 and is equal to:
C1.S(i) + C2.S(i+1) + C3.S(i+2).....+ C64.S(i+63)

This equation comprises a 64 sample correlation between the code values C1....C64 and the signal samples S(i)....S(i+63). After the first 64 samples have been entered, each successive signal sample creates a new 64 point correlation computed in the following manner:
S(i+1)...S(i+64)
S(i+2)...S(i+65)
.....and so forth.

The resulting correlations are a combination of the code symbols C1...C64 with 64 signal samples selected according to a sliding window 64 samples wide. Thus this type of matched filter may also be called a sliding correlator.

The matched filter of FIGURE 1 is required to perform 64 multiplications and 63 additions during each sample period of the clock. A complex correlator may employ four of the matched filters of FIGURE 1 to compute the inner products in the equation:
Cr.Sr, Ci.Si, Cr.Si, Ci..Sr
where Cr is an N-element vector of the real code symbols, Sr is a vector comprising the real parts of the last N input samples, Ci is an N-element vector of imaginary code symbols and Si is a vector comprising imaginary part of the last N input samples.

The complex correlation of these vectors is given by:

Cr.Sr+Ci.Si; for the real part of the desired correlation;
Cr.Si-Ci.Sr; for the imaginary part of the desired correlation.

It is implicitly assumed that the desired correlation is between any N input samples Sr and the complex conjugate of the N sample code (Cr, Ci), thus giving rise to the exemplary choice of plus and minus signs in the above example.

Prior art filters for producing complex correlation values use four of the above described matched filter, thus requiring, 4N multiplication processes, 4(N-1) addition processes and 4(N-1) delay elements in order to achieve the complex correlation value. If some method could be found to reduce the number of multiplication, addition and delays performed to obtain each successive correlation value, a dramatic reduction in the power consumed by the equipment forming the complex correlations would be realized. In applications such as cellular telephones where battery life considerations are paramount such a solution would be of great benefit.

SUMMARY OF THE INVENTION

The present invention overcomes the foregoing and other problems with a matched filter for computing complex correlations between a sequence of complex input samples and a complex code which utilizes less additions and multiplications than those utilized in currently existing complex matched filter. The matched filter includes a set of N changeover switches. The switches each have a first input connected to the real value portion of the input sample values and a second input connected to the imaginary values portion of the input sample values. A control input receives control signals controlling a pair of outputs from the changeover switches. In response to application of a control signal in a first state, the real values are output over a first output of the changeover switches and the imaginary values are output on the second output of the changeover switch. When the control signal moves to a second state the situation is reversed such that imaginary values are output on the first output and real values are output on the second output.

The first outputs of the set of N changeovers are connected with a matched filter portion for generating a real portion of a complex correlation. A first set of N multipliers are connected to the first outputs of the changeover switches. A second input of the N multipliers are connected to receive real symbols of a complex code. The multiplied outputs are applied to the first set of (N-1) adders which add the multiplied outputs of the N multipliers with a corresponding delayed sum to generate an undelayed sum. A set of (N-1) delay elements delay the undelayed sums to produce delayed sums. The first of the undelayed sums comprises an output of the first multiplier rather than an output of an adder. The output of a last adder comprises the real portion of the complex correlation. A second matched filter portion is coupled to the second output of the N changeover switches and is configured in a similar manner as the first matched filter portion. The second matched filter generates the imaginary portion of the complex correlation from the last adder.

BRIEF DESCRIPTION OF THE DRAWINGS

For a more complete understanding of the present invention, reference is made to the following Detailed Description taken in conjunction with the accompanying drawings wherein:

FIGURE 1 is an illustration of a prior art sliding correlator;
FIGURE 2 is an illustration of a complex sliding correlator employing four of the prior art correlators illustrated in FIGURE 1;
FIGURE 3 is a matched filter according to the present invention; and
FIGURE 4 is an alternative embodiment of a matched filter according to the present invention.

DETAILED DESCRIPTION OF THE INVENTION

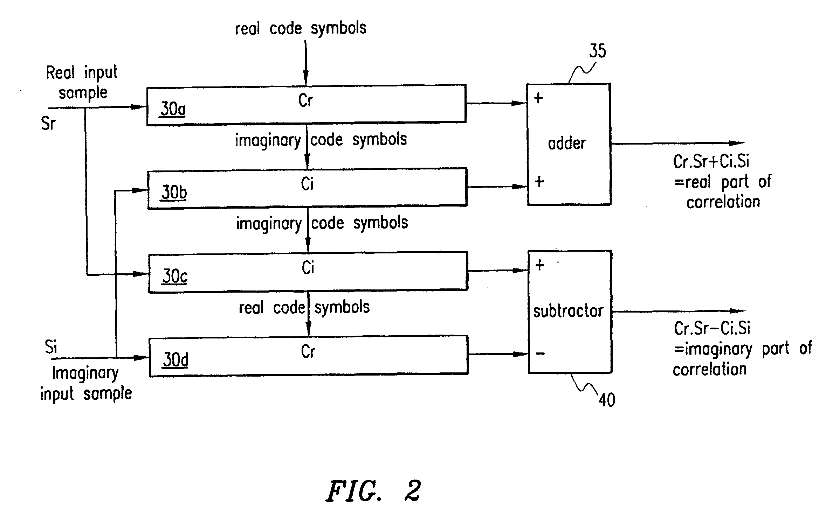

Referring now to the drawings, and more particularly to FIGURE 2, there is illustrated a complex matched filter 30 comprising four of the prior art matched filters 5 illustrated in FIGURE 1. Matched filter 30a computes the inner product of Cr.Sr at each sample clock cycle, where Cr is an N-element vector of real code symbol values and Sr is an N-element vector comprising the real part of the last N input samples. Matched filter 30b computes Ci.Si, where Ci is an N-element vector of imaginary code symbol values and Si is a vector of the imaginary parts of the last N input samples. Adder 35 combines the outputs of matched filter 30a (Cr.Sr) and the output of matched filter 30b (Ci.Si) to form a real part of the desired complex correlation at each sample cycle.

Similarly, matched filters 30c and 30d compute Ci.Sr and Cr.Si, respectively, and the output of the matched filters 30c and 30d are combined in subtractor 40 to form the imaginary portion of a desired complex correlation at each sample cycle. U.S. Patent Application No. 08/748,755 filed on 1/14/96, and entitled "Despreading of Direct Sequence Spread Spectrum Communication Signals" which disclosure is incorporated herein by reference, discloses how to perform a complex correlation between sample (Sr + jSi) and a code (Cr + jCi) using only two real correlations, by first rotating the code through 45 degrees. The rotation of (Cr+jCi) through 45 degrees is equivalent to multiplying the sample vector by (1 + j), apart from a scaling of the $\sqrt{2}$ where j in the above equals the square root of -1. This provides:

$$(Cr+jCi)\ (1+j) = (Cr-Ci)+j(Cr+ci)$$

When this rotated code is correlated with Sr+jSi (i.e., Sr+jSi is multiplied by the complex conjugate of the code), we obtain:

$$(Cr-Ci).Sr + (Cr+Ci).Si$$

as the real result of the complex correlation; and

$$(Cr-Ci).Si - (Cr+Ci).Sr$$

as the imaginary result of the complex correlation.

If the code symbols Cr and Ci are binary bits which, in arithmetic notation have the value either +1 or -1, either Cr and Ci have the same sign, i.e., both +1 or both -1, in which case the Cr-Ci terms above are zero, or Cr and Ci have opposite signs in which case the (Cr+Ci) terms are zero. Thus, only two of the above four terms can be non-zero after application of the 45 degree rotation step.

It will be appreciated by persons of ordinary skill in the art that correlating a signal Sr+jSi which is received through a radio channel that introduces an arbitrary phase shift is essentially unaffected by correlating the signal with the rotated code. Correlation with the rotated code merely gives a correlation result which is also rotated. This is equivalent to the radio signal having been propagated through one eighth of a wavelength greater distance, which in typical cellular telephone systems is on the order of an inch. This is of no significance to the radio receiver. If for some reason this distance was of significance, the correlation results could be derotated to 45 degrees by adding and subtracting the real and imaginary results. The resulting correlation of this operation is exactly a factor of two higher than it would have been with the prior art correlator illustrated in FIGURE 2. This factor could be eliminated by dividing the non zero one of the Cr+Ci or Cr-Ci by two to obtain values of +/-1 instead of +/-2.

In the above equations, if a specific one of Cr is equal to the corresponding Ci, the value 0.5(Cr+Ci).Si = Cr. Si or Ci.Si is added to the accumulated real result, and the 0.5(Cr+Ci).Sr = Cr.Sr or Ci.Sr is subtracted from the accumulated imaginary result. Conversely, if a specific one of Cr and the corresponding Ci have opposite signs, then 0.5 (Cr-Ci).Sr = Cr.Sr or -Ci.Sr is additively accumulated to the real results and 0.5(Cr-Ci).Si = Cr.Si or -Ci.Si is additively accumulated to the imaginary result. These results may be regularized by eliminating the need to subtract in one case by reformulating it as follows:

> If Cr=Ci, then add Cr.Si to the real result and add
> -Ci.Sr to the imaginary result;
> If Cr=-Ci, then add Cr.Sr to the real result and add
> -Ci.Si to the imaginary result.

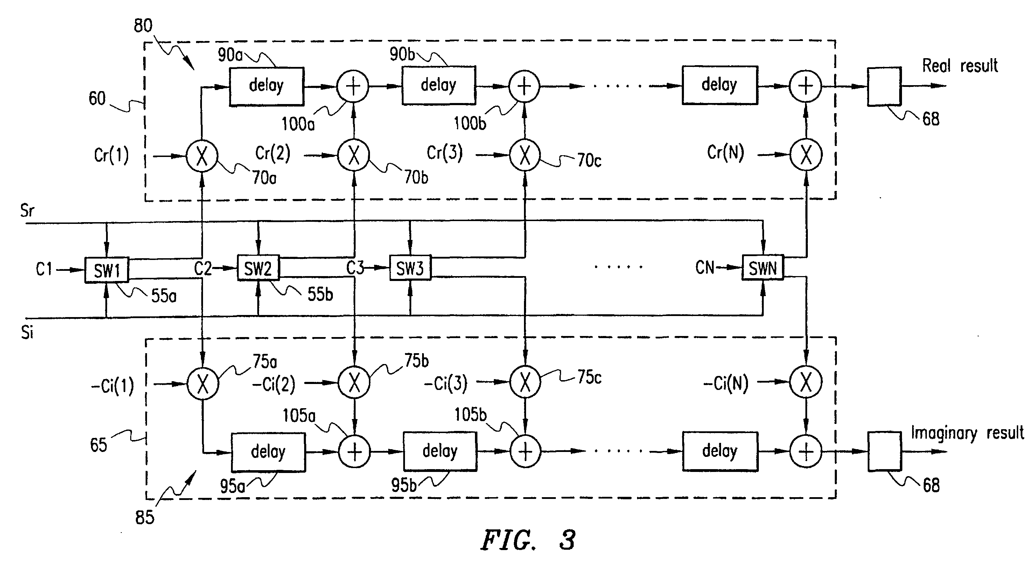

The only difference between the two cases is that Sr and Si are interchanged in the second case compared to the first case. This may be accomplished according to the present invention by using a swapping switch (which will be more fully discussed in a moment) controlled in response to whether Cr=Ci or -Ci. An implementation of this is more fully described in FIGURE 3.

A complex input sample stream consisting of a real portion Sr and an imaginary portion Si is applied to a pair of inputs of the matched filter 50. The real portion of the sample stream Sr is fed to a first input of each of N changeover switches 55. The imaginary portion of the input sample stream Si is fed to a second switch input of each of the changeover switches 55. The changeover switches are controlled by code values C1, C2, C3...CN which are respectively given by:

$$C1=Cr(1)*Ci(1)$$

$$C2=Cr(2)*Ci(2)$$

$$CN=Cr(N)*Ci(N)$$

The operator "*" means exclusive-OR if the values are regarded as having the Boolean values "1" or "0". Alternatively, the operator "*" means to multiply if the values are regarded as having the values +1 (equivalent to Boolean "0" or -1 (equivalent to Boolean "1"). The values C1, C2...CN may be preformed codes and do not change during the correlation with a fixed code Cr, Ci.

The changeover switches 55 are arranged to route the real input sample value Sr to the upper matched filter 60 if the control value is Boolean "1" and the imaginary input sample value Si to the lower matched filter 65. If the control value is Boolean "0", the real sample value is routed to the lower matched filter 65 and the imaginary value is routed to the upper matched filter 60.

The values routed to the upper matched filter 60 are multiplied in multipliers 70 by respective real code values Cr(1), Cr(2)...Cr(N), while values routed to the lower matched filter 65 are multiplied in multipliers 75 with respective imaginary code values -Ci(1), -Ci(2)...-Cl(N), which have been negated or complemented by the 45 degree rotation as described above. It is not necessary to complement or negate each of these values as it is equivalent if the imaginary complex correlation result from the lower matched filter 65 is negated. The sign changes are unimportant as long as they are known and can be "fixed" in subsequent processing.

The upper matched filter 60 and lower matched filter 65 multiplier outputs 70, 75 are accumulated in delay-and-add chains 80 and 85, respectively. The delay-and-add chain 80 comprises a first delay circuit 90 having an input connected to the output of multiplier 70a. The output of the delay circuit 90a is connected to an adder 95a. The adder 95a has a second input connected to the output of multiplier 70b. The adder 95a adds together the output from delay circuit 90a and the output of multiplier 70b. The output of adder 95a is applied to a next delay circuit and adder in a similar fashion.

The delay-and-add chain 85 is configured in a similar manner, where the first delay circuit 95a has its input connected to the output of multiplier 75a. An adder 105a has two inputs connected to the output of delay circuit 95 and to the output of multiplier 75b. The output of adder 105 is applied to the next delay circuit 95b, and the process is repeated through the chain in a similar manner.

Multiplier outputs are accumulated in the delay-and-add chains 80 for the upper matched filter 60 and in the delay chain of 85 for the lower matched filter 65. The outputs from the last adders 100N and 105N form the desired real and imaginary portions, respectively, of the complex correlation signal apart from the scaling by $1/\sqrt{2}$ and a 45 degree angle shift. The scaling and angle shift can be "fixed" by using a Butterfly circuit 68 to form the sum and difference of the real and imaginary results.

When values Cr and Ci are binary bits, the multipliers 70, 75 are reduced to sign changers. Sign changing may also be approximated by complementing the values, or, if sign-magnitude representation is used for Sr,Si, may be exactly performed by complementing. The delay elements 90 and 95 may be registers which are loaded with the value presented at their inputs synchronously upon occurrence of each new input sample clock pulse. The loaded value then appears on the outputs after occurrence of the next clock pulse. Adders 100 and 105 may be parallel adders that operate with multi-bit input values presented simultaneously. The word-length of the multi-bit values increases for each subsequent adder as the possible value for the accumulated result increases from left to right.

For example, if the input values Sr,Si are 4-bit values of up to +/-7, the output of adders 100a and 105b may be up to +/-14, which requires 5 bits to represent. The value from adders 100b and 105b may be up to +/-21 which requires 6 bits to represent. This process continues as illustrated in the table below. For input values of length 4 bits ranging symmetrically positive and negative from +7 to -7, the word length after each adder is as indicated below in Table 1:

Table 1

| output of adder 1 | 5 bits maximum values +14 to -14 |
|---|---|
| adder 2 | 6 bits  "   "   +21 to -21 |
| adder 3 | 6 bits  "   "   +28 to -28 |
| adder 4 | 7 bits  "   "   +35 to -35 |
| adder 5 | 7 bits  "   "   +42 to -42 |
| adder 6 | 7 bits  "   "   +49 to -49 |
| adder 7 | 7 bits  "   "   +56 to -56 |
| adder 8 | 7 bits  "   "   +63 to -63 |

For a length N=64 correlator, the maximum values from the 64th adder would be +/-448. This requires a 10-bit representation. The bit-width of the delay elements thus must be adapted to the above word lengths.

If serial arithmetic is used, values to be added are presented to an adder one bit at a time. The least significant bit is presented first. To build a 64-stage correlator for 4-bit input values, ten-bit serial words would be appropriate.

This requires a serial bit-clock at a frequency of at least ten times the sample clock rate. This is reasonable up to an input sample rate of a few megahertz. The delay elements would be required to be ten-bit serial shift-registers, or alternatively, a reduced power configuration in which bits are recorded in sequential positions of a ten-bit memory after removing the bit written into the same location ten clock cycles earlier. This technique is referred to as "moving pointers" rather than "moving data" and leads to fewer logic nodes changing state per second, and thus lowers power consumption.

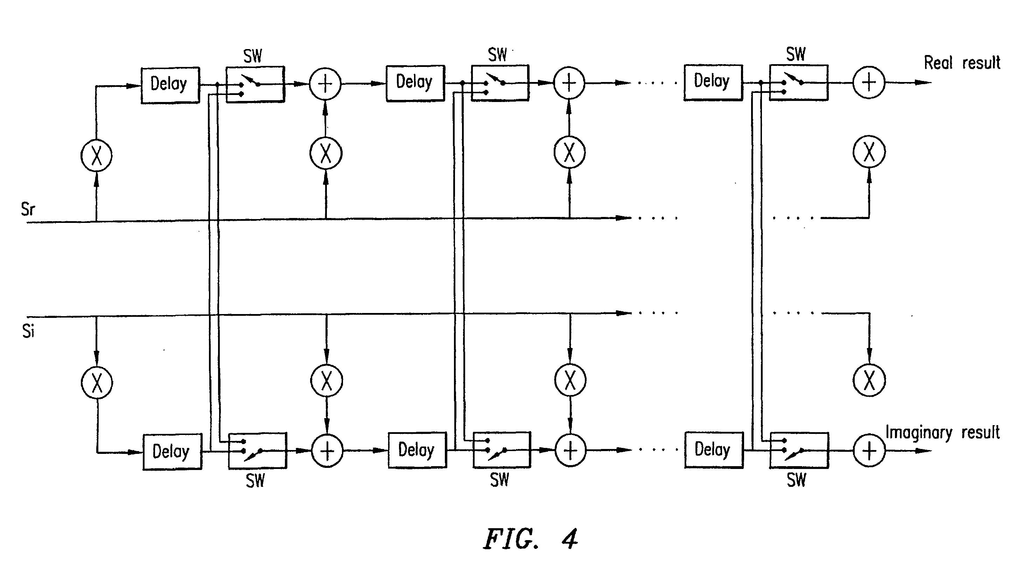

An alternative embodiment of the invention is illustrated in FIGURE 4 wherein changeover switch 55 is used to swap the outputs of delay circuits 90 and 95 before they are applied to the adders 100 and 105, respectively. Such a configuration has a disadvantage in that for parallel arithmetic operation, the number of bits that have to be switched increases from left to right. Instead of remaining equal to the wordlength of input values Sr,Si. Thus, FIGURE 3 represents a preferred implementation for a sequential matched filter that does not compute precombinations of input values.

Although a preferred embodiment of the method and apparatus of the present invention has been illustrated in the accompanying Drawings and described in the foregoing Detailed Description, it is understood that the invention is not limited to the embodiment disclosed, but is capable of numerous rearrangements, modifications, and substitutions.

**Claims**

1. A matched filter for computing a complex correlation between a sequence of complex input samples values and a complex code, comprising:

   a set of N changeover switches (55), each switch including a first input connected to receive a real value part (Sr) of the input sample values, a second input connected to receive an imaginary value part (Si) of the input sample values and a control input connected to receive a control signal (C), wherein application of the control signal (C) in a first state switches the real value part (Sr) of the input sample values to a first output and switches the imaginary value part (Si) of the input sample values to a second output and application of the control signal (C) in a second state switches output of the real value part (Sr) of the input sample values to the second output and switches output of the imaginary value part (Si) of the input sample values to the first output;
   a first matched filter portion (60) coupled to each of the first outputs of the N changeover switches (55) for generating a real portion of the complex correlation; and
   a second matched filter portion (65) coupled to each of the second outputs of the N changeover switches (55) for generating an imaginary portion of the complex correlation.

2. The matched filter of claim 1, wherein the first matched filter portion (60) comprises:

   a first set of N multipliers (70) each having a first input connected to one of the first outputs of the N changeover switches (55) and a second input connected to receive real symbols (Cr) of the complex code for providing a multiplied output;
   a first set of (N-1) adders (100) for adding the multiplied output of a respective one of said first N multipliers (70) with a corresponding delayed sum to provide an undelayed sum, wherein an output of a last of the (N-1) adders (100) is the real portion of the complex correlation; and
   a first set of (N-1) delay elements (90) for delaying the undelayed sums to produce the delayed sums, wherein one of said undelayed sums is an output of a first set of said first set of N multipliers (70).

3. The matched filter of claim 1, wherein the second matched filter portion (65) comprises:

   a second set of N multipliers (75) each having a first input connected to one of the first outputs of the N changeover switches (55) and a second input connected to receive imaginary symbols (Ci) of the complex code for providing a multiplied output;
   a second set of (N-1) adders (105) for adding the multiplied output of a respective one of said first N multipliers (75) with a corresponding delayed sum to provide an undelayed sum, wherein an output of a last of the (N-1) adders (105) is the imaginary portion of the complex correlation; and
   a second set of (N-1) delay elements (95) for delaying the undelayed sums to produce the delayed sums, wherein one of said undelayed sums is an output of a first set of said second set of N multipliers (75).

4. The matched filter of claim 1, wherein the control signal (C) comprises a combination of a respective real symbol with a corresponding imaginary symbol.

5. The matched filter of claim 1, wherein the real and imaginary parts of the complex input sample values (Sr, Si) are each L-bit binary values.

6. The matched filter of claim 5, wherein the first and second switch inputs comprise L-bit inputs.

7. The matched filter of claim 2, wherein the first set of (N-1) delay elements (90) comprises registers which review an input on a first clock cycle and output the input on the next clock cycle.

8. The matched filter of claim 3, wherein the second set of (N-1) delay elements (95) comprises registers which review an input on a first clock cycle and output the input on the next clock cycle.

9. The matched filter of claim 2, wherein the first set of adders (100) comprises parallel adders.

10. The matched filter of claim 3, wherein the second set of adders (105) comprises parallel adders.

11. An improved method for correlating complex signal values with a complex code, comprising the steps of:

generating switch control values (C);
selecting either a real part (Cr) or an imaginary part (Ci) of a complex signal value using a switch (55) responsive to the switch control values (C);
combining the selected real or imaginary part with a previously combined result to produce a new combined result.

12. The method of claim 11, wherein the step of generating further comprises combining corresponding real and imaginary part of symbols of the complex codes.


**Patentansprüche**

1. Ein Wurzel-Nyquist-Filter zum Berechnen einer komplexen Korrelation zwischen einer Folge von komplexen Eingangsabtastwerten und einem komplexen Code, umfassend:

einen Satz von N Umschaltern (55), wobei jeder Schalter einen ersten Eingang einschließt, verbunden zum Empfangen eines Realwertteil (Sr) der Eingangsabtastwerte, einen zweiten Eingang, verbunden zum Empfangen eines Imaginärwertteils (Si) der Eingangsabtastwerte und einen Steuereingang, verbunden zum Empfangen eines Steuersignals (C), wobei das Anlegen des Steuersignals (C) in einem ersten Zustand den Realwertteil (Sr) der Eingangsabtastwerte zu einem ersten Ausgang schaltet und dem Imaginärwertteil (Si) der Eingangsabtastwerte zu einem zweiten Ausgang und das Anlegen des Steuersignals (C) in einem zweiten Zustand die Ausgabe des Realwertteils (Sr) der Eingangsabtastwerte zu dem zweiten Ausgang schaltet und die Ausgabe des Imaginärwertteil (Si) der Eingangsabtastwerte zu den ersten Ausgang;

einen ersten Wurzel-Nyquist-Filterabschnitt (60), gekoppelt an jeden der ersten Ausgänge der N Umschalter (55) zum Generieren eines Realteils der komplexen Korrelation; und

einen zweiten Wurzel-Nyquist-Filterabschnitt (65), gekoppelt an jeden der zweiten Ausgänge der N Umschalter (55) zum Generieren eines Imaginärteils der komplexen Korrelation.

2. Wurzel-Nyquist-Filter nach Anspruch 1, wobei der erste Wurzel-Nyquist-Filterabschnitt (60) umfasst:

einen ersten Satz von N Multiplizierern (70), jeden mit einem ersten Eingang verbunden an einen der ersten Ausgänge der N Umschalter (55) und einem zweiten Eingang verbunden zum Empfangen von Realsymbolen (Cr) des komplexen Codes zum Bereitstellen einer multiplizierten Ausgangsgröße;

einen ersten Satz von (N-1) Addierern (100) zum Addieren der multiplizierten Ausgangsgrößen eines jeweiligen der ersten N Multiplizierer (70) mit einer entsprechenden verzögerten Summe zum Bereitstellen einer unverzögerten Summe, wobei eine Ausgangsgröße eines letzten der (N-1) Addierer (100) der Realteil der komplexen Korrelation ist; und

einen ersten Satz von (N-1) Verzögerungselementen (90) zum Verzögern der unverzögerten Summen zum Produzieren der verzögerten Summen, wobei eine der unverzögerten Summen eine Ausgangsgröße eines ersten Satzes des ersten Satzes von N Multiplizierern (70) ist.

3. Wurzel-Nyquist-Filter nach Anspruch 1, wobei der zweite Wurzel-Nyquist-Filterabschnitt (65) umfasst:

einen zweiten Satz von N Multiplizierern (75), jeden mit einem ersten verbunden an einen der ersten Ausgänge der N Umschalter (55) und einem zweiten Eingang verbunden zum Empfangen von Imaginärsymbol (Ci) durch komplexen Code zum Bereitstellen einer multiplizierten Ausgangsgröße;

einen zweiten Satz von (N-1) Addierern (105) zum Addieren der multiplizierten Ausgangsgrößen eines jeweiligen der ersten N Multiplizierer (75) mit einer entsprechenden verzögerten Summe zum Bereitstellen einer unverzögerten Summe, wobei eine Ausgangsgröße eines letzten der (N-1) Addierer (105) der Imaginärteil der komplexen Korrelation ist; und

einen zweiten Satz von (N-1) Verzögerungselementen (95) zum Verzögern der unverzögerten Summen zum Produzieren der verzögerten Summen, wobei eine der unverzögerten Summen eine Ausgangsgröße eines ersten Satzes des zweiten Satzes von N Multiplizierern (75) ist.

4. Wurzel-Nyquist-Filter nach Anspruch 1, wobei das Steuersignal (C) eine Kombination eines jeweiligen Realsymbols mit einem entsprechenden Imaginärsymbol umfasst.

5. Wurzel-Nyquist-Filter nach Anspruch 1, wobei die Realund Imaginärteile der komplexen Eingangsabtastwerte (Sr, Si) jeweil L-Bit Binärwerte sind.

6. Wurzel-Nyquist-Filter nach Anspruch 5, wobei die ersten und zweiten Schaltereingangsgrößen L-Bit Eingangsgrößen umfassen.

7. Wurzel-Nyquist-Filter nach Anspruch 2, wobei der erste Satz von (N-1) Verzögerungselementen (90) Register umfasst, welche eine Eingangsgröße in einem ersten Taktyklus bearbeiten und die Eingangsgröße in dem nächsten Taktzyklus ausgeben.

8. Wurzel-Nyquist-Filter nach Anspruch 3, wobei der zweite Satz von (N-1) Verzögerungselementen (95) Register umfasst, welche eine Eingangsgröße in einen ersten Taktyklus bearbeiten und die Eingangsgröße in dem nächsten Taktzyklus ausgeben.

9. Wurzel-Nyquist-Filter nach Anspruch 3, wobei der erste Satz von Addierern (100) Paralleladdierer umfasst.

10. Wurzel-Nyquist-Filter nach Anspruch 3, wobei der zweite Satz von Addierern (105) Paralleladdierer umfasst.

11. Ein verbessertes Verfahren zum Korrelieren komplexer Signalwerte mit einem komplexen Code, die folgenden Schritte umfassend:

Generieren von Schaltsteuerwerten (C) ;

Auswählen entweder eines Realteils (Cr) oder eines Imaginärteils (Ci) eines komplexen Signalwertes unter Verwendung eines Schalters (55) ansprechend auf die Schaltsteuerwerte (C);

Kombinieren des gewählten Real- oder Imaginärteils mit einem vorangegangenen kombinierten Ergebnis zum Produzieren eines neuen kombinierten Ergebnisses.

12. Verfahren nach Anspruch 11, wobei der Schritt des Generierens außerdem das Kombinieren entsprechender Real- und Imaginärteile von Symbolen komplexen Codes umfasst.

**Revendications**

1. Filtre adapté destiné à calculer une corrélation complexe entre une séquence de valeurs complexes d'échantillons d'entrée et un code complexe, comprenant :

   un ensemble de N commutateurs (55) de permutation, chaque commutateur comprenant une première entrée connectée pour recevoir une partie valeur réelle (Sr) des valeurs d'échantillon d'entrée, une seconde entrée connectée pour recevoir une partie valeur imaginaire (Si) des valeurs d'échantillon d'entrée et une entrée de commande connectée pour recevoir un signal (C) de commande, dans lequel l'application du signal (C) de commande dans un premier état commute la partie valeur réelle (Sr) des valeurs d'échantillon d'entrée vers une première sortie et commute la partie valeur imaginaire (Si) des valeurs d'échantillon d'entrée vers une seconde sortie et l'application du signal (C) de commande dans un second état commute la sortie de la partie valeur réelle (Sr) des valeurs d'échantillon d'entrée vers la seconde sortie et commute la sortie de la partie valeur imaginaire (Si) des valeurs d'échantillon d'entrée vers la première sortie ;
   une première partie (60) de filtre adapté raccordée à chacune des premières sorties des N commutateurs (55) de permutation pour engendrer une partie réelle de la corrélation complexe ; et
   une seconde partie (65) de filtre adapté raccordée à chacune des secondes sorties des N commutateurs (55) de permutation pour engendrer une partie imaginaire de la corrélation complexe.

2. Filtre adapté selon la revendication 1, dans lequel la première partie (60) de filtre adapté comprend :

   un premier ensemble de N multiplieurs (70) ayant chacun une première entrée connectée à l'une des premières sorties des N commutateurs (55) de permutation et une seconde entrée connectée pour recevoir des symboles réels (Cr) du code complexe pour délivrer une sortie multipliée ;
   un premier ensemble de (N-1) additionneurs (100) destiné à additionner la sortie multipliée de l'un, respectif, desdits premiers N multiplieurs (70) avec une somme correspondante retardée pour donner une somme non retardée, dans lequel une sortie du dernier des (N-1) additionneurs (100) est la partie réelle de la corrélation complexe ; et
   un premier ensemble de (N-1) éléments (90) à retard destiné à retarder les sommes non retardées pour produire les sommes retardées, dans lequel l'une desdites sommes non retardées est une sortie d'un premier ensemble dudit premier ensemble de N multiplieurs (70).

3. Filtre adapté selon la revendication 1, dans lequel la seconde partie (65) de filtre adapté comprend :

   un second ensemble de N multiplieurs (75) ayant chacun une première entrée connectée à l'une des premières sorties des N commutateurs (55) de permutation et une seconde entrée connectée pour recevoir des symboles imaginaires (Ci) du code complexe pour délivrer une sortie multipliée ;
   un second ensemble de (N-1) additionneurs (105) destiné à additionner la sortie multipliée de l'un, respectif, desdits premiers N multiplieurs (75) avec une somme correspondante retardée pour donner une somme non retardée, dans lequel une sortie d'un dernier des (N-1) additionneurs (105) est la partie imaginaire de la corrélation complexe ; et
   un second ensemble de (N-1) éléments (95) à retard destiné à retarder les sommes non retardées pour produire les sommes retardées, dans lequel l'une desdites sommes non retardées est une sortie d'un premier ensemble dudit second ensemble de N multiplieurs (75).

4. Filtre adapté selon la revendication 1, dans lequel le signal (C) de commande comprend une combinaison d'un symbole réel respectif avec un symbole imaginaire correspondant.

5. Filtre adapté selon la revendication 1, dans lequel les parties réelle et imaginaire des valeurs complexes d'échantillon d'entrée (Sr, Si) sont chacune des valeurs binaires à L bits.

6. Filtre adapté selon la revendication 5, dans lequel les première et seconde entrées de commutateur comprennent des entrées à L bits.

7. Filtre adapté selon la revendication 2, dans lequel le premier ensemble de (N-1) éléments (90) à retard comprend des registres qui renouvellent une entrée lors d'un premier cycle d'horloge et qui sortent l'entrée lors du cycle d'horloge suivant.

8. Filtre adapté selon la revendication 3, dans lequel le second ensemble de (N-1) éléments (95) à retard comprend des registres qui renouvellent une entrée lors d'un premier cycle d'horloge et qui sortent l'entrée lors du cycle d'horloge suivant.

9. Filtre adapté selon la revendication 2, dans lequel le premier ensemble d'additionneurs (100) comprend des additionneurs parallèles.

10. Filtre adapté selon la revendication 3, dans lequel le second ensemble d'additionneurs (105) comprend des additionneurs parallèles.

11. Procédé amélioré de corrélation de valeurs complexes de signal avec un code complexe, comprenant les étapes :

de production de valeurs (C) de commande de commutation ;
de sélection soit d'une partie réelle (Cr) soit d'une partie imaginaire (Ci) d'une valeur complexe de signal en utilisant un commutateur (55) sensible aux valeurs (C) de commande de commutateur ;
de combinaison de la partie réelle ou imaginaire sélectionnée avec un résultat combiné antérieurement pour produire un nouveau résultat combiné.

12. Procédé selon la revendication 11, dans lequel l'étape de production comprend en outre la combinaison de parties réelle et imaginaire correspondantes de symboles de codes complexes.

*FIG. 1*

real code symbols

Real input
sample

Sr

| 30a | Cr |

imaginary code symbols

| 30b | Ci |

imaginary code symbols

| 30c | Ci |

real code symbols

Si

| 30d | Cr |

Imaginary
input sample

35

adder

+

+

Cr.Sr+Ci.Si
=real part of
correlation

subtractor

+

−

Cr.Sr−Ci.Si
=imaginary part of
correlation

40

FIG. 2

Real result

68

delay

Cr(N)

SWN

CN

Cr(1)

60

80

90b · delay · 100b · Cr(3) · 70c

70b · 100a · Cr(2) · 70a

SW3 · C3

SW2 · 55b · C2

SW1 · 55a

C1

Sr

Si

65

85

-Ci(1)

-Ci(2) · 75a · 105a

-Ci(3) · 75b · 75c · 105b

delay · 95a

delay · 95b

delay

-Ci(N)

68

delay

Imaginary result

FIG. 3

FIG. 4